# EUROPEAN PATENT APPLICATION

(11) **EP 4 650 790 A1**
(43) Date of publication of application: **19.11.2025**
(21) Application number: 25156724.4
(22) Date of filing: 10.02.2025
(51) Int. Cl.: G01R 13/02

(54) **MEASUREMENT DEVICE ALLOWING FOR SIMULTANEOUS MULTI-CHANNEL WIDEBAND ACQUISITION**

(30) Priority: 14.05.2024 US 202418663950
(71) Applicant: Rohde & Schwarz GmbH & Co. KG, 81671 München (DE)
(72) Inventor: Pliquett, Jochen, 85625 Glonn (DE); Cirillo, Dr. Luke, 85586 Poing (DE); Feldhaus, Dr. Gregor, 97209 Veitshöchheim (DE); Lagler, Andreas, 83026 Rosenheim (DE)
(74) Representative: Rupp, Christian

(57) **Abstract**

A measurement device for performing measurements with respect to a device under test, DUT, is provided. Said measurement device comprises multiple measurement channels for measuring an input signal having a repetitive nature in at least one sub-band. In this context, the multiple measurement channels are configured to have phase and time coherence between the multiple measurement channels. In addition to this, the measurement device is configured to perform simultaneous acquisitions with the aid of the multiple measurement channels such that the corresponding sequence of the simultaneous acquisitions comprises the at least one repetitive sub-band in one of the multiple measurement channels, wherein at least one further one of the multiple measurement channels propagates in frequency and/or switches DUT channels, especially to extend the corresponding bandwidth and/or number of measurable DUT channels. Further additionally, the measurement device is configured to align the simultaneous acquisitions in time and/or phase using the at least one repetitive sub-band and/or a repetitive sub-band that is common between the simultaneous acquisitions.

## Description

### Technical Field

The disclosure relates to measurement devices allowing for simultaneous multi-channel wideband acquisition, especially virtually simultaneous multi-channel wideband acquisition. In particular, the disclosure relates to measurement devices with multiple channels for performing measurements with respect to a device under test with single or multiple channels, wherein each channel can have a wider bandwidth than the measurement devices support. Furthermore, the number of the channels of the measurement devices can be significantly smaller than the number of the channels of the device under test.

### Background Art

Generally, in times of an increasing number of wireless communication applications, and thus an increasing number of devices with single or multiple outputs, such as a phased-array antenna with a frontend, there is a growing need of measurement devices allowing for simultaneous multi-channel wideband acquisition to perform measurements with respect to such single- or multi-output devices, respectively, for verifying correct functioning of said applications in a highly accurate and efficient manner, wherein not only a plurality of device under test output channels can be measured with much less measurement channels but also each channel can have a wider bandwidth than the measurement devices support.

For instance, prior art document US 10,164,670 B2 discloses methods and systems for using a single receiving device, such as a single vector signal analyzer (VSA), to capture and digitize multiple time-domain acquisitions of a repeating signal at different center frequencies, to create a single time-domain waveform having a bandwidth greater than the acquisition bandwidth of the receiving device. Specifically, one or more signal processing paths process the multiple digitized acquisitions of the repeating signal, either sequentially or in parallel, such that the processed acquisitions are aggregated into a representation of one or more repetitions of the repeating signal.

Disadvantageously, whereas said methods and systems for using a single receiving device may enable creating a single time-domain waveform having a bandwidth greater than the acquisition bandwidth of the receiving device, such methods and systems do not allow for a simultaneous multi-channel wideband acquisition.

Further disadvantageously, repetitive signal components must be present in the overlapping sub-bands of all adjacent acquisition bands in frequency. If the corresponding signal has gaps in one of the overlapping sub-bands, the methods and systems according to the above-mentioned prior art document fail. For example, said methods said methods and systems are not able to deal with a signal with a non-contiguous spectrum.

### Summary

There is a need to provide measurement devices allowing for simultaneous multi-channel wideband acquisition, especially virtually simultaneous multi-channel wideband acquisition, thereby advantageously achieving particularly accurate and efficient measurements, wherein each channel can have a wider bandwidth than the measurement devices support and the number of the channels of the measurement devices can be significantly smaller than the number of the channels of the device under test.

This is achieved by the embodiments provided in the enclosed independent claims. Advantageous implementations of the present disclosure are further defined in the dependent claims.

According to a first aspect of the disclosure, a measurement device for performing measurements with respect to a device under test, DUT, is provided. Said measurement device comprises multiple measurement channels for measuring an input signal having a repetitive nature in at least one sub-band of at least one DUT channel. In this context, the multiple measurement channels are configured to have phase and time coherence between the multiple measurement channels. In addition to this, the measurement device is configured to perform simultaneous acquisitions with the aid of the multiple measurement channels such that the corresponding sequence of the simultaneous acquisitions comprises the at least one repetitive sub-band in one of the multiple measurement channels, wherein at least one further one of the multiple measurement channels propagates in frequency and/or switches DUT channels, especially to extend the corresponding bandwidth and/or number of measurable DUT channels. Further additionally, the measurement device is configured to align the simultaneous acquisitions in time and/or phase using the at least one repetitive sub-band and/or a repetitive sub-band that is common between the simultaneous acquisitions.

Advantageously, particularly accurate and efficient measurements can be achieved, wherein each channel can have a wider bandwidth than the measurement devices support and the number of the channels of the measurement devices can be significantly smaller than the number of the channels of the device under test.

Further advantageously, a (virtual) single acquisition of one or multiple DUT channels can be achieved, wherein each channel can have a very wide or even an arbitrary acquisition bandwidth. It is noted that a (virtual) multi-channel channel acquisition with arbitrary bandwidth per input channel or DUT channel, respectively, can be got. It is further noted that the foregoing term "arbitrary bandwidth" may especially be understood as a kind of an infinite bandwidth or a virtual infinite bandwidth, respectively.

With respect to the above-mentioned multiple measurement channels, it is noted that said multiple measurement channels can also be understood as internal measurement channels or internal acquisition channels, respectively, of the measurement device. Accordingly, it is possible that the measurement device comprises a single input or a single input channel, respectively, which may especially be routed for connection to the multiple measurement channels, preferably within the measurement device. Alternatively, it is possible that the measurement device comprises multiple inputs or multiple input channels, respectively, which may especially be routed for connection to the multiple measurement channels, preferably within the measurement device.

With respect to the above-mentioned input signal, it is noted that it might be particularly advantageous if said input signal has a non-contiguous spectrum. Accordingly, it might be particularly advantageous if the above-mentioned input signal having a repetitive nature in at least one sub-band of at least one DUT channel is an input signal having a non-contiguous spectrum and a repetitive nature in at least one sub-band of at least one DUT channel. In this context, it is noted that said non-contiguous spectrum may especially be understood in a manner that the input signal has gaps, especially in frequency, in one or at least one of the sub-bands, especially overlapping sub-bands.

According to an implementation form of the first aspect of the disclosure, the measurement device is configured to perform an inter-channel synchronization, especially with respect to the multiple measurement channels. In addition to this or as an alternative, the measurement device is configured to perform an inter-acquisition synchronization, especially with respect to the simultaneous and/or subsequent acquisitions. Advantageously, for instance, coherent channels can efficiently be achieved. Further advantageously, spectral gluing and/or I/Q gluing can be achieved in a particularly efficient manner.

With respect to the above-mentioned inter-channel synchronization, it is noted that it might be particularly advantageous if said inter-channel synchronization comprises achieving corresponding phase coherence and/or achieving corresponding time synchronization and/or correcting the corresponding level. Additionally or alternatively, said inter-channel synchronization may especially be performed only once, preferably before start of the corresponding measurement.

Furthermore, with respect to the above-mentioned inter-acquisition synchronization, it is noted that it might be particularly advantageous if said inter-acquisition synchronization is only performed once, preferably before start of the corresponding measurement, especially for the case that the corresponding timing and phase coherence is maintained, or said inter-acquisition synchronization is performed per corresponding acquisition.

According to a further implementation form of the first aspect of the disclosure, the simultaneous acquisitions comprise or are simultaneous In-phase/Quadrature, I/Q, data acquisitions. In addition to this or as an alternative, the repetitive nature comprises or is a periodic nature. Advantageously, for example, complexity can be reduced, thereby increasing efficiency.

According to a further implementation form of the first aspect of the disclosure, the measurement device is configured to cross-correlate and/or average and/or combine the simultaneous acquisitions, especially over correspondingly subsequent acquisitions. Advantageously, for instance, efficiency can further be increased.

According to a further implementation form of the first aspect of the disclosure, the measurement device comprises at least one filter, especially a filter bank, for filtering the simultaneous acquisitions and/or for dividing the simultaneous acquisitions into corresponding multiple sub-bands. Advantageously, for example, complexity, and thus inefficiencies, can be reduced.

According to a further implementation form of the first aspect of the disclosure, the measurement device is connectable and/or connected to a splitting and/or switching matrix, especially for mapping the corresponding DUT channels to the multiple measurement channels, preferably at certain acquisition times. Advantageously, for instance, with the aid of said splitting and/or switching matrix, especially a splitting portion thereof, it can efficiently be achieved to simultaneously measure the same channel in two or more measurement channels. Further advantageously, with the aid of said splitting and/or switching matrix, especially a switching portion thereof, it can efficiently be achieved to cycle through all output channels of the DUT.

According to a further implementation form of the first aspect of the disclosure, the measurement device comprises the splitting and/or switching matrix. In addition to this or as an alternative, the measurement device is configured to perform a de-embedding of the splitting and/or switching matrix. Advantageously, for example, effects of the splitting and/or switching matrix can be compensated for in a particularly efficient manner.

According to a second aspect of the disclosure, a measurement device for performing measurements with respect to a device under test, DUT, is provided. Said measurement device comprises multiple measurement channels for measuring an input signal having a repetitive nature in at least one sub-band. In this context, the multiple measurement channels are configured to have phase and time coherence between the multiple measurement channels. In addition to this, the measurement device is configured to perform simultaneous acquisitions with the aid of the multiple measurement channels such that the corresponding sequence of the simultaneous acquisitions comprises the at least one repetitive sub-band in one of the multiple measurement channels, wherein at least one further one of the multiple measurement channels propagates in frequency, especially to extend the corresponding bandwidth. Further additionally, the measurement device is configured to align the simultaneous acquisitions in time and/or phase using the at least one repetitive sub-band and/or a repetitive sub-band that is common between the simultaneous acquisitions.

Advantageously, particularly accurate and efficient measurements can be achieved, wherein each channel can have a wider bandwidth than the measurement devices support and the number of the channels of the measurement devices can be significantly smaller than the number of the channels of the device under test.

Further advantageously, a (virtual) single acquisition of one or multiple DUT channels can be achieved, wherein each channel can have a very wide or even an arbitrary acquisition bandwidth. It is noted that a (virtual) multi-channel channel acquisition with arbitrary bandwidth per input channel or DUT channel, respectively, can be got. It is further noted that the foregoing term "arbitrary bandwidth" may especially be understood as a kind of an infinite bandwidth or a virtual infinite bandwidth, respectively.

With respect to the above-mentioned input signal, it is noted that it might be particularly advantageous if said input signal has a non-contiguous spectrum. Accordingly, it might be particularly advantageous if the above-mentioned input signal having a repetitive nature in at least one sub-band of at least one DUT channel is an input signal having a non-contiguous spectrum and a repetitive nature in at least one sub-band of at least one DUT channel. In this context, it is noted that said non-contiguous spectrum may especially be understood in a manner that the input signal has gaps, especially in frequency, in one or at least one of the sub-bands, especially overlapping sub-bands.

According to an implementation form of the second aspect of the disclosure, the measurement device is configured to perform an inter-channel synchronization, especially with respect to the multiple measurement channels. In addition to this or as an alternative, the measurement device is configured to perform an inter-acquisition synchronization, especially with respect to the simultaneous and/or subsequent acquisitions. Advantageously, for instance, coherent channels can efficiently be achieved. Further advantageously, spectral gluing and/or I/Q gluing can be achieved in a particularly efficient manner.

According to a further implementation form of the second aspect of the disclosure, the simultaneous acquisitions comprise or are simultaneous In-phase/Quadrature, I/Q, data acquisitions. In addition to this or as an alternative, the repetitive nature comprises or is a periodic nature. Advantageously, for example, complexity can be reduced, thereby increasing efficiency.

According to a further implementation form of the second aspect of the disclosure, the measurement device is configured to cross-correlate and/or average and/or combine the simultaneous acquisitions, especially over correspondingly subsequent acquisitions. Advantageously, for instance, efficiency can further be increased.

According to a further implementation form of the second aspect of the disclosure, the measurement device comprises at least one filter, especially a filter bank, for filtering the simultaneous acquisitions and/or for dividing the simultaneous acquisitions into corresponding multiple sub-bands. Advantageously, for example, complexity, and thus inefficiencies, can be reduced.

According to a further implementation form of the second aspect of the disclosure, the measurement device is connectable and/or connected to a splitting and/or switching matrix, especially for mapping the corresponding DUT channels to the multiple measurement channels, preferably at certain acquisition times. Advantageously, for instance, with the aid of said splitting and/or switching matrix, especially a splitting portion thereof, it can efficiently be achieved to simultaneously measure the same channel in two measurement channels. Further advantageously, with the aid of said splitting and/or switching matrix, especially a switching portion thereof, it can efficiently be achieved to cycle through all output channels of the DUT.

With respect to the above-mentioned splitting and/or switching matrix, it is noted that said splitting and/or switching matrix can especially be a splitting and/or switching matrix being external to the measurement device. Accordingly, the splitting and/or switching matrix and the measurement device may not share a common housing.

According to a further implementation form of the second aspect of the disclosure, the measurement device comprises the splitting and/or switching matrix. In addition to this or as an alternative, the measurement device is configured to perform a de-embedding of the splitting and/or switching matrix. Advantageously, for example, effects of the splitting and/or switching matrix can be compensated for in a particularly efficient manner.

Again, with respect to the splitting and/or switching matrix, it is noted that said splitting and/or switching matrix can especially be a splitting and/or switching matrix being internal to the measurement device. Accordingly, the splitting and/or switching matrix and the measurement device may share a common housing.

It is further noted that the a part of the splitting and/or switching matrix can be external to the measurement device and another part of the splitting and/or switching matrix can be internal to the measurement device. Accordingly, a part of the splitting and/or switching matrix and the measurement device may not share a common housing, and another part of the splitting and/or switching matrix and the measurement device may share a common housing.

According to a third aspect of the disclosure, a measurement device for performing measurements with respect to a device under test, DUT, is provided. Said measurement device comprises multiple measurement channels for measuring an input signal having a repetitive nature in at least one sub-band. In this context, the multiple measurement channels are configured to have phase and time coherence between the multiple measurement channels. In addition to this, the measurement device is configured to perform simultaneous acquisitions with the aid of the multiple measurement channels such that the corresponding sequence of the simultaneous acquisitions comprises the at least one repetitive sub-band in one of the multiple measurement channels, wherein at least one further one of the multiple measurement channels propagates in at least one DUT channel, especially to extend the corresponding number of measurable DUT channels. Further additionally, the measurement device is configured to align the simultaneous acquisitions in time and/or phase using the at least one repetitive sub-band and/or a repetitive sub-band that is common between the simultaneous acquisitions.

Advantageously, particularly accurate and efficient measurements can be achieved, wherein each channel can have a wider bandwidth than the measurement devices support and the number of the channels of the measurement devices can be significantly smaller than the number of the channels of the device under test.

Further advantageously, a (virtual) single acquisition of one or multiple DUT channels can be achieved, wherein each channel can have a very wide or even an arbitrary acquisition bandwidth. It is noted that a (virtual) multi-channel channel acquisition with arbitrary bandwidth per input channel or DUT channel, respectively, can be got. It is further noted that the foregoing term "arbitrary bandwidth" may especially be understood as a kind of an infinite bandwidth or a virtual infinite bandwidth, respectively.

With respect to the above-mentioned input signal, it is noted that it might be particularly advantageous if said input signal has a non-contiguous spectrum. Accordingly, it might be particularly advantageous if the above-mentioned input signal having a repetitive nature in at least one sub-band of at least one DUT channel is an input signal having a non-contiguous spectrum and a repetitive nature in at least one sub-band of at least one DUT channel. In this context, it is noted that said non-contiguous spectrum may especially be understood in a manner that the input signal has gaps, especially in frequency, in one or at least one of the sub-bands, especially overlapping sub-bands.

According to an implementation form of the third aspect of the disclosure, the measurement device is configured to perform an inter-channel synchronization, especially with respect to the multiple measurement channels. In addition to this or as an alternative, the measurement device is configured to perform an inter-acquisition synchronization, especially with respect to the simultaneous and/or subsequent acquisitions. Advantageously, for instance, coherent channels can efficiently be achieved. Further advantageously, spectral gluing and/or I/Q gluing can be achieved in a particularly efficient manner.

According to a further implementation form of the third aspect of the disclosure, the simultaneous acquisitions comprise or are simultaneous In-phase/Quadrature, I/Q, data acquisitions. In addition to this or as an alternative, the repetitive nature comprises or is a periodic nature. Advantageously, for example, complexity can be reduced, thereby increasing efficiency.

According to a further implementation form of the third aspect of the disclosure, the measurement device is configured to cross-correlate and/or average and/or combine the simultaneous acquisitions, especially over correspondingly subsequent acquisitions. Advantageously, for instance, efficiency can further be increased.

According to a further implementation form of the third aspect of the disclosure, the measurement device comprises at least one filter, especially a filter bank, for filtering the simultaneous acquisitions and/or for dividing the simultaneous acquisitions into corresponding multiple sub-bands. Advantageously, for example, complexity, and thus inefficiencies, can be reduced.

According to a further implementation form of the third aspect of the disclosure, the measurement device is connectable and/or connected to a splitting and/or switching matrix, especially for mapping the corresponding DUT channels to the multiple measurement channels, preferably at certain acquisition times. Advantageously, for instance, with the aid of said splitting and/or switching matrix, especially a splitting portion thereof, it can efficiently be achieved to simultaneously measure the same channel in two measurement channels. Further advantageously, with the aid of said splitting and/or switching matrix, especially a switching portion thereof, it can efficiently be achieved to cycle through all output channels of the DUT.

According to a further implementation form of the third aspect of the disclosure, the measurement device comprises the splitting and/or switching matrix. In addition to this or as an alternative, the measurement device is configured to perform a de-embedding of the splitting and/or switching matrix. Advantageously, for example, effects of the splitting and/or switching matrix can be compensated for in a particularly efficient manner.

Furthermore, the disclosure relates to a measurement system which may especially be understood as a fourth aspect of the disclosure. Said measurement system comprises a measurement device according to at least one of the first, the second, or the third aspect of the disclosure, and a DUT.

With respect to the DUT, it is noted that the DUT can comprise multiple channels, preferably multiple output channels, more preferably multiple phase-synchronized output channels, most preferably multiple phase-synchronized radio frequency output channels or multiple phase-synchronized intermediate frequency output channels or multiple phase-synchronized baseband output channels. For instance, the DUT can comprise or be a phased-array antenna especially with a frontend.

It might be particularly advantageous if the number of the multiple channels of the DUT is greater than the number of the multiple measurement channels of the measurement device. For example, the DUT may comprise at least four channels. Further exemplarily, the measurement device may comprise at least two measurement channels, preferably two or three measurement channels.

With respect to the above-mentioned splitting and/or switching matrix in accordance with at least one of the first aspect, the second aspect, or the third aspect of the disclosure, it is noted that, especially instead of the measurement device, the measurement system can comprise such a splitting and/or switching matrix.

It is further noted that the measurement system can comprise at least a part of the elements of the measurement device according to at least one of the first aspect, the second aspect, or the third aspect of the disclosure or any of its implementation forms, respectively, which the measurement device comprises, especially instead of the respective implementation form of the measurement device. Accordingly, in a particular case, the measurement system may be formed by replacing the term "measurement device" by "measurement system".

Moreover, the disclosure relates to a measurement method for performing measurements with respect to a device under test, DUT, which may especially be understood as a fifth aspect of the disclosure. Said measurement method comprises the steps of:
- measuring an input signal having a repetitive nature in at least one sub-band with the aid of multiple measurement channels of a measurement device or a measurement system for performing measurements with respect to the DUT, the multiple measurement channels configured to have phase and time coherence between the multiple measurement channels,
- performing simultaneous acquisitions with the aid of the multiple measurement channels such that the corresponding sequence of the simultaneous acquisitions comprises the at least one repetitive sub-band in one of the multiple measurement channels, wherein at least one further one of the multiple measurement channels propagates in frequency and/or switches DUT channels, especially to extend the corresponding bandwidth and/or number of measurable DUT channels, and
- aligning the simultaneous acquisitions in time and/or phase using the at least one repetitive sub-band and/or a repetitive sub-band that is common between the simultaneous acquisitions with the aid of the measurement device or the measurement system.

With respect to the measurement device mentioned in the context of the measurement method, it is noted that the measurement device can especially be a measurement device according to at least one of the first aspect, the second aspect, or the third aspect of the disclosure. In this exemplary case, especially due to the at least one further one of the multiple measurement channels propagating in frequency and/or in at least one DUT channel, the measurement device can be a measurement device according to the first aspect of the disclosure.

By analogy therewith, with respect to the measurement system mentioned in the context of the measurement method, it is noted that the measurement system can especially be a measurement system according to the above-mentioned measurement system which may especially be understood as the fourth aspect of the disclosure.

Furthermore, the disclosure relates to a computer program with program code means to make at least a part of the steps or all steps of the above-mentioned measurement method, which may especially be understood as a fifth aspect of the disclosure, if the program is loaded on a computer or digital signal processor or a measurement device or a measurement system. Said computer program may especially be understood as a sixth aspect of the disclosure.

With respect to the measurement device mentioned in the context of the computer program, it is noted that the measurement device can especially be a measurement device according to at least one of the first aspect, the second aspect, or the third aspect of the disclosure. In this exemplary case, especially due to the at least one further one of the multiple measurement channels propagating in frequency and/or in at least one DUT channel, the measurement device can be a measurement device according to the first aspect of the disclosure.

By analogy therewith, with respect to the measurement system mentioned in the context of the computer program, it is noted that the measurement system can especially be a measurement system according to the above-mentioned measurement system which may especially be understood as the fourth aspect of the disclosure.

### Brief Description of the Drawings

The above-described aspects and implementation forms of the present disclosure will be explained in the following description of specific embodiments in relation to the enclosed drawings, in which:
Fig. 1A shows an exemplary embodiment of a measurement device according to the first aspect or the second aspect or the third aspect of the disclosure;
Fig. 1B shows a further exemplary embodiment based on Fig. 1A;
Fig. 2 shows a further exemplary embodiment of a measurement device;
Fig. 3 shows a further exemplary embodiment of a measurement device;
Fig. 4 shows a further exemplary embodiment of a measurement device;
Fig. 5A shows a diagram illustrating the corresponding functioning of the embodiment according to Fig. 4;
Fig. 5B shows an exemplary multi-channel acquisition result as a consequence of Fig. 5A;
Fig. 6A shows a further exemplary embodiment of a measurement device in combination with a diagram illustrating the corresponding functioning of said measurement device;
Fig. 6B shows an exemplary multi-channel acquisition result as a consequence of Fig. 6A;
Fig. 7 shows an exemplary diagram further illustrating I/Q stitching as it can exemplarily be performed by the measurement device of Fig. 6A; and
Fig. 8 shows a flow chart of an exemplary embodiment of a measurement method.

### Detailed Descriptions of Embodiments

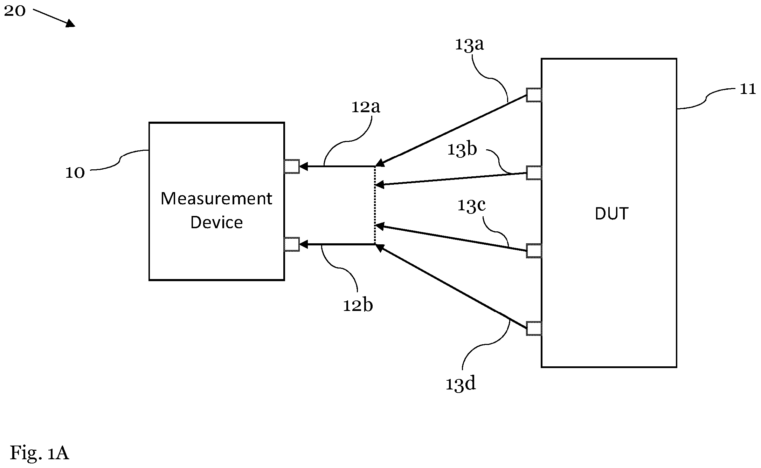

With respect to Fig. 1A, an exemplary embodiment of a measurement device 10 for performing measurements with respect to a device under test 11, DUT. Due to the fact that each of the measurement devices according to the first aspect, the second aspect, and the third aspect of the present disclosure basically have the same structure, the exemplary illustration according to Fig. 1A can be seen as a measurement device according to the first aspect or the second aspect or the third aspect of the disclosure.

In accordance with each of the first aspect, the second aspect, and the third aspect of the disclosure, the measurement device 10 comprises multiple measurement channels, exemplarily two measurement channels 12a, 12b, for measuring an input signal having a repetitive nature in at least one sub-band, wherein the multiple measurement channels or the two measurement channels 12a, 12b, respectively, are configured to have phase and time coherence between the multiple measurement channels or said two measurement channels 12a, 12b, respectively.

It is noted that it might be particularly advantageous if the measurement device 10 is configured to guide a user through the corresponding multiple acquisitions and/or to ask the user when to connect which DUT output(s) to which measurement device input(s).

In accordance with the first aspect of the disclosure, the measurement device 10 is configured to perform simultaneous acquisitions with the aid of the multiple measurement channels or the two measurement channels 12a, 12b, respectively, such that the corresponding sequence of the simultaneous acquisitions comprises the at least one repetitive sub-band in one of the multiple measurement channels or the two measurement channels 12a, 12b, respectively, wherein at least one further one of the multiple measurement channels or the two measurement channels 12a, 12b, respectively, propagates in frequency and/or in at least one DUT channel, exemplarily in at least one of the four DUT channels 13a, 13b, 13c, 13d, especially to extend the corresponding bandwidth and/or number of measurable DUT channels or the four DUT channels 13a, 13b, 13c, 13d, respectively.

Alternatively, in accordance with the second aspect of the disclosure, the measurement device 10 is configured to perform simultaneous acquisitions with the aid of the multiple measurement channels or the two measurement channels 12a, 12b, respectively, such that the corresponding sequence of the simultaneous acquisitions comprises the at least one repetitive sub-band in one of the multiple measurement channels or the two measurement channels 12a, 12b, respectively, wherein at least one further one of the multiple measurement channels or the two measurement channels 12a, 12b, respectively, propagates in frequency, especially to extend the corresponding bandwidth.

Further alternatively, in accordance with the third aspect of the disclosure, the measurement device 10 is configured to perform simultaneous acquisitions with the aid of the multiple measurement channels or the two measurement channels 12a, 12b, respectively, such that the corresponding sequence of the simultaneous acquisitions comprises the at least one repetitive sub-band in one of the multiple measurement channels or the two measurement channels 12a, 12b, respectively, wherein at least one further one of the multiple measurement channels or the two measurement channels 12a, 12b, respectively, propagates in at least one DUT channel, exemplarily in at least one of the four DUT channels 13a, 13b, 13c, 13d, especially to extend the corresponding number of measurable DUT channels or of the four DUT channels 13a, 13b, 13c, 13d, respectively.

In addition to this, in accordance with each of the first aspect, the second aspect, and the third aspect of the disclosure, the measurement device 10 is configured to align the simultaneous acquisitions in time and/or phase using the at least one repetitive sub-band and/or a repetitive sub-band that is common between the simultaneous acquisitions.

It is noted that it might be particularly advantageous if the measurement device 10 is configured to perform an inter-channel synchronization, especially with respect to the multiple measurement channels or the two measurement channels 12a, 12b, respectively. In addition to this or as an alternative, the measurement device 10 may be configured to perform an inter-acquisition synchronization, especially with respect to the simultaneous and/or subsequent acquisitions.

It is further noted that it might be particularly advantageous if the simultaneous acquisitions comprise or are simultaneous In-phase/Quadrature, I/Q, data acquisitions. Additionally or alternatively, the repetitive nature comprises or is a periodic nature.

Moreover, it should be noted that it might be particularly advantageous if the measurement device 10 is configured to cross-correlate and/or average and/or combine the simultaneous acquisitions, especially over correspondingly subsequent acquisitions.

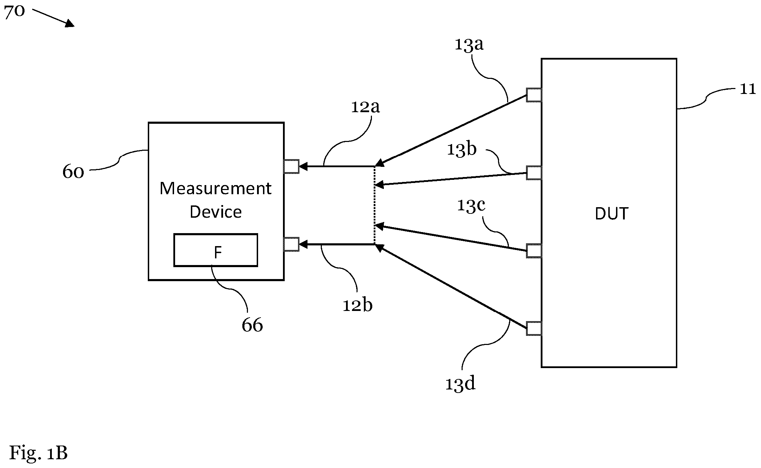

As it can especially be seen from Fig. 1B showing an exemplary measurement device 60 based on the measurement device 10 of Fig. 1A, it might be particularly advantageous if the measurement device 60 comprises at least one filter 66, especially a filter bank, for filtering the simultaneous acquisitions and/or for dividing the simultaneous acquisitions into corresponding multiple sub-bands.

For the sake of completeness, it is noted that each of Fig. 1A and Fig. 1B additionally illustrates an exemplary embodiment of a measurement system 20 or 70, respectively. Such a measurement system 20 or 70, respectively, may especially be understood as the above-mentioned fourth aspect of the present disclosure. In accordance with Fig. 1A and Fig. 1B, the measurement system 20 comprises the measurement device 10 and the DUT 11, whereas the measurement system 70 comprises the measurement device 60 and the DUT 11.

Furthermore, it might be particularly advantageous if the measurement device 10 or 60, respectively, is connectable and/or connected to a splitting and/or switching matrix, especially for mapping the corresponding DUT channels to the multiple measurement channels, preferably at certain acquisition times.

In this context, it is noted that it might be particularly advantageous if the measurement device 10 or the measurement device 60, respectively, is configured to perform a de-embedding of the splitting and/or switching matrix.

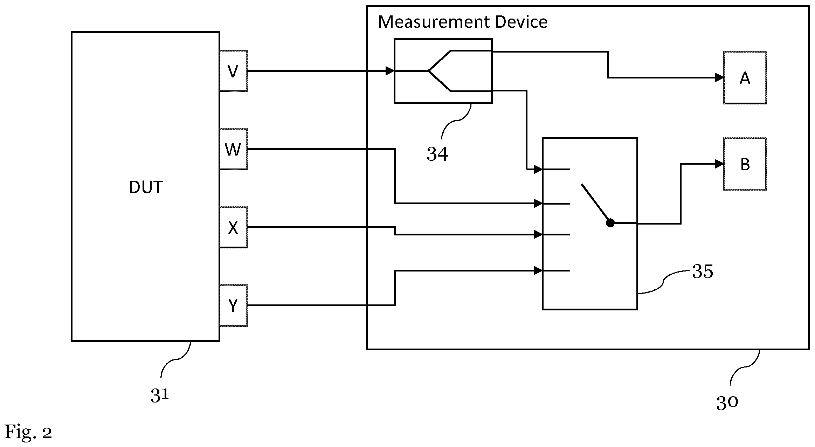

As it can exemplarily be seen from Fig. 2 illustrating a further exemplary embodiment of a measurement device 30 for performing measurements with respect to a DUT 31, it might be particularly advantageous if the measurement device 30 comprises such a splitting and/or switching matrix.

In particular, in this exemplary case according to Fig. 2, the measurement device 30 or the splitting and/or switching matrix, respectively, comprises a splitter 34 and a switch 35. For instance, as it can be seen, the splitter is 34 is configured to provide one input signal at two outputs. Furthermore, the switch 35 is exemplarily configured to switch the corresponding signal of four inputs to one output.

As it can further be seen from Fig. 2, the measurement device 30 exemplarily comprises two measurement channels denoted as "A" and "B", such as the two measurement channels 12a, 12b of the above-mentioned measurement device 10 or the measurement device 60, respectively. Moreover, the DUT 31 exemplarily comprises four DUT channels denoted as "V", "W", "X", and "Y", such as the four DUT channels 13a, 13b, 13c, 13d of the above-mentioned DUT 11 of Fig. 1A or Fig. 1B, respectively.

With respect to the measurement device 30, it is noted that the corresponding functioning thereof is identical or substantially identical to the functioning of the above-mentioned measurement device 10 or 60, respectively.

Again, with respect to the splitter 34 and the switch 35 of said measurement device 30 or said splitting and/or switching matrix, respectively, it is noted that one of the DUT channels, exemplarily the DUT channel "V", is provided for one measurement channel, exemplarily measurement channel "A", and for one input of the switch 35 with the aid of the splitter 34. Furthermore, the remaining DUT channels, exemplarily the DUT channels "W", "X", "Y", are provided for the remaining inputs of the switch 35. The output of the switch 35 is exemplarily provided for the remaining measurement channel, exemplarily measurement channel "B".

Accordingly, it might be particularly advantageous if one of the DUT channels, exemplarily DUT channel "V", is provided for one measurement channel, exemplarily measurement channel "A". Moreover, especially in this context, it might be particularly advantageous if all DUT channels, exemplarily DUT channels "V", "W", "X", "Y", are provided for at least one remaining measurement channel, exemplarily measurement channel "B", in a switched manner, and/or if the remaining DUT channels, exemplarily DUT channels "W", "X", "Y", are provided for at least one remaining measurement channel in a switched manner.

In other words, it might be particularly advantageous if the above-mentioned splitting and/or switching matrix is configured to provide one of the DUT channels for one measurement channel. Additionally or alternatively, it might be particularly advantageous if the above-mentioned splitting and/or switching matrix is configured to provide all DUT channels for at least one remaining measurement channel, especially in a switched and/or cycled manner, and/or to provide the remaining DUT channels for at least one remaining measurement channel, especially in a switched and/or cycled manner.

With respect to the above-mentioned switch 35, it is further noted that it might be particularly advantageous if said switch 35 is configured to cycle through all DUT channels, exemplarily DUT channels "V", "W", "X", "Y".

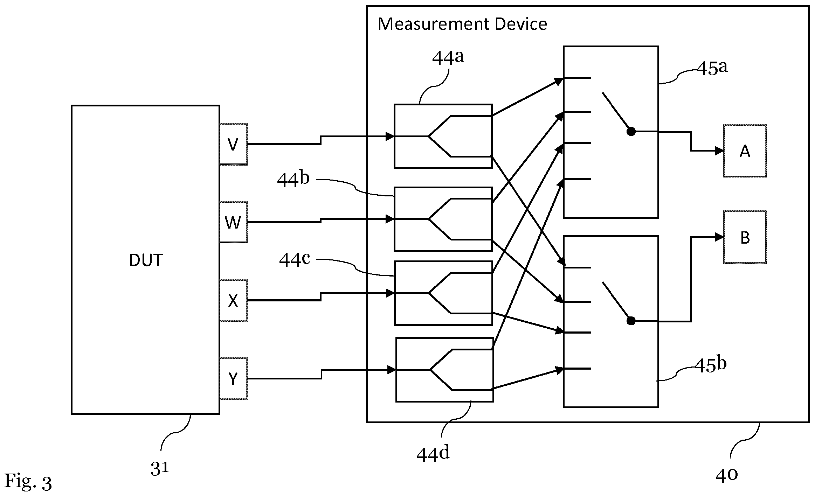

Now, with respect to Fig. 3, a further exemplary embodiment of a measurement device 40 is depicted. Said measurement device 40 differs from the above-mentioned measurement device 30 according to Fig. 2 especially in that the measurement device 40 or the splitting and/or switching matrix, respectively, comprises four splitters 44a, 44b, 44c, 44d, and two switches 45a, 45b instead of the above-mentioned splitter 34 and switch 35.

Exemplarily, each of said four splitters 44a, 44b, 44c, 44d is configured in a manner as the above-mentioned splitter 34. Accordingly, an input of such a splitter is provided at two outputs or said input is passed to said two outputs, respectively, especially in a simultaneous manner. As it can be seen from Fig. 3, one splitter is provided is for each DUT channel. In other words, in this exemplary case, the number of splitters is equal to the number of DUT channels.

Further exemplarily, each of the two switches 45a, 45b is configured in a manner as the above-mentioned switch 35. Accordingly, the corresponding signals of four inputs of such a switch are provided for or passed to, respectively, one output of such a switch in a switched and/or cycled manner. With respect to the foregoing term "provided for", it is noted that throughout the present disclosure, the wording "provided for" may especially be understood as "passed to". Accordingly, the corresponding parts, wherein (a signal of) one is provided for or passed to, respectively, another, may especially comprise a connection between each other.

As it can further be seen from Fig. 3, a first output of each of the splitters 44a, 44b, 44c, 44d is exemplarily connected to a corresponding input of the first switch 45a, whereas a second output of each of said splitters 44a, 44b, 44c, 44d is exemplarily connected to a corresponding input of the second switch 45b.

Accordingly, it might be particularly advantageous if the above-mentioned splitting and/or switching matrix is configured to provide each DUT channel for each measurement channel or to pass each DUT channel to each measurement channel, respectively, especially in a switched and/or cycled manner.

With general respect to embodiments according to the measurement device 40 of Fig. 3, it is noted that it might be particularly advantageous if the measurement device comprises a splitter or a splitting portion of the splitting and/or switching matrix, respectively, for each DUT channel, especially for the case that the corresponding phases of the DUT channels drift.

With general respect to embodiments according to the measurement device 30 of Fig. 2, it is noted that it might be particularly advantageous if the measurement device comprises a splitter or a splitting portion of the splitting and/or switching matrix, respectively, for one DUT channel, especially for the case that the DUT channels have phase-coherent signals with the same repetitiveness and/or periodicity.

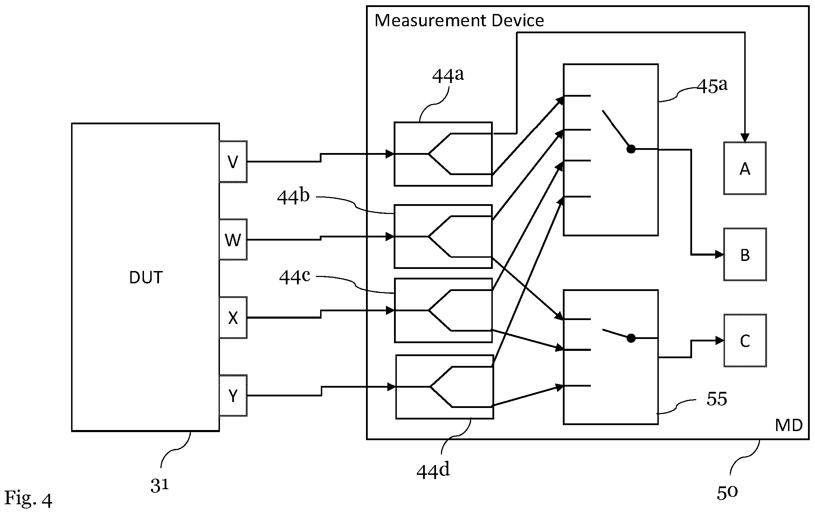

Now, with respect to Fig. 4, a further exemplary embodiment of a measurement device 50 is illustrated. Said measurement device 50 differs from the above-mentioned measurement 40 of Fig. 3 especially in that the measurement device 50 additionally comprises a third measurement channel denoted as "C". Furthermore, the second switch 45b of the measurement device 40 has been replaced by a switch 55. Said switch 55 is configured such that the corresponding signals of three inputs of said switch 55 are provided for or passed to, respectively, an output of said switch 55, especially in a switched and/or cycled manner.

As it can further be seen from said Fig. 4, one of the DUT channels, exemplarily DUT channel "V", is provided for one of the measurement channels, exemplarily measurement channel "A" especially with the aid of one of the splitters, exemplarily splitter 44a. Furthermore, all the DUT channels, exemplarily DUT channels "V", "W", "X", "Y", are provided for another one of the measurement channels, exemplarily measurement channel "B", especially in a switched and/or cycled manner, preferably with the aid of all splitters, exemplarily splitters 44a, 44b, 44c, 44d, and one of the switches, exemplarily switch 45a. Moreover, the remaining DUT channels, especially besides the one DUT channel provided for just one measurement channel, exemplarily DUT channels "W", "X", "Y", are provide for another one of the measurement channels, exemplarily measurement channel "C", especially in a switched and/or cycled manner, preferably with the aid of the remaining splitters, exemplarily splitters 44b, 44c, 44d, and another one of the switches, exemplarily switch 55.

Accordingly, it might be particularly advantageous if the above-mentioned splitting and/or switching matrix is configured to provide/pass one of the DUT channels for/to one measurement channel. Additionally or alternatively, it might be particularly advantageous if the above-mentioned splitting and/or switching matrix is configured to provide/pass all DUT channels for/to at least one remaining measurement channel, preferably for/to one further measurement channel, especially in a switched and/or cycled manner, and/or to provide/pass the remaining DUT channels, especially besides the one of the DUT channels provided for/passed to one measurement channel, for/to at least one remaining measurement channel, preferably for/to another further measurement channel, especially in a switched and/or cycled manner.

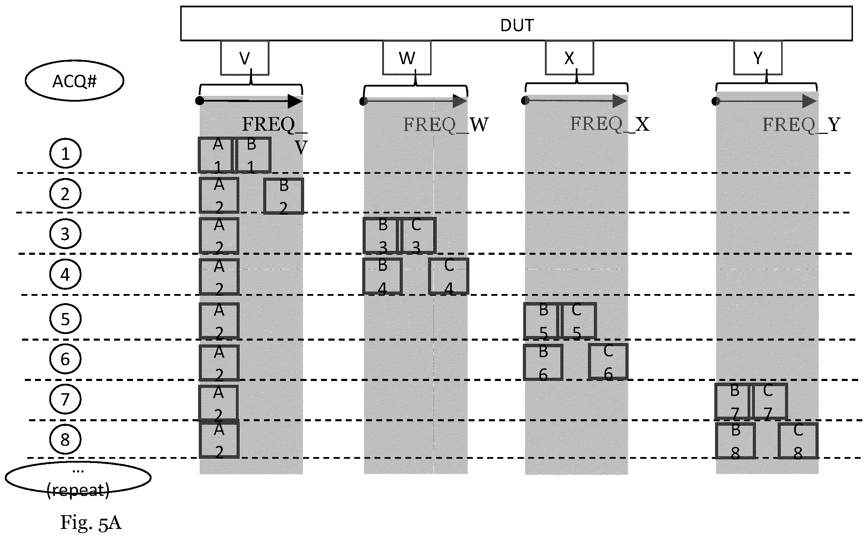

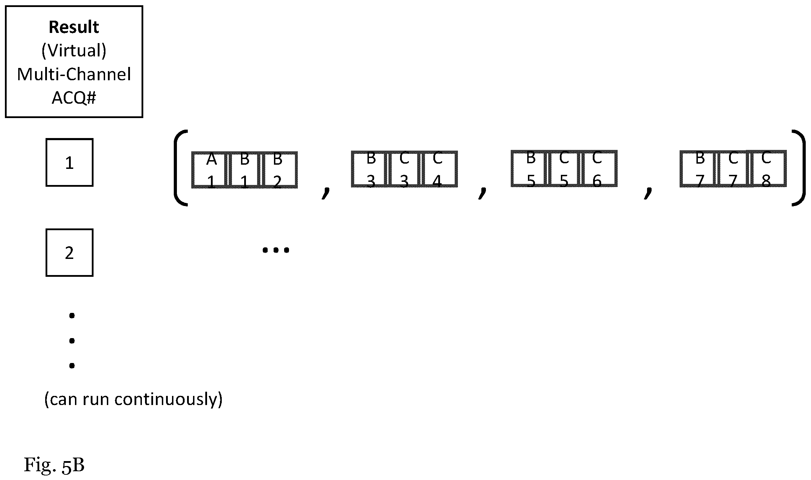

Furthermore, the corresponding functioning of the measurement device 50 according to Fig. 4 is exemplarily illustrated with the aid of a diagram, especially one possible switching pattern for the measurement device 50, shown in Fig. 5A and, in accordance with Fig. 5B, an exemplary multi-channel acquisition result resulting from said diagram or said one possible switching pattern for the measurement device 50, respectively.

As already indicated above, the measurement device 50 comprises three measurement channels, exemplarily the measurement channels "A", "B", and "C". In accordance with Fig. 5A, it might be particularly advantageous to define three measurement bands: A first measurement band, especially a global reference band, preferably always using one of the measurement channels, exemplarily measurement channel "A", a second measurement band, especially a local reference band and/or a current channel reference band, preferably always using a further one of the measurement channels, exemplarily measurement channel "B", and a third measurement band, especially a stepped and/or switched measurement band, preferably using said further one and/or another further one of the measurement channels, exemplarily measurement channels "B" and/or "C".

Moreover, in the light of Fig. 5A and Fig. 5B, it is noted that, especially to get more multi-channel acquisitions, the pattern of acquisitions ACQ#1 to #8 may preferably be repeated.

For the sake of completeness, it is further noted that the illustration according to Fig. 5A or Fig. 5B, respectively, can correspondingly be adapted in order to analogously apply for a measurement device with two measurement channels or another number of measurement channels.

Again, with respect to the measurement device 50 of Fig. 4, it is further noted that it might be particularly advantageous if the measurement device 50 is configured to measure imperfect phases of at least two measurement channels against each other, exemplarily imperfect phases of measurement channel "W" versus measurement channel "V". In this context, it might be particularly advantageous if the measurement device 50 is configured to show said imperfect phases as a measurement result.

Furthermore, it is noted that it might be particularly advantageous if the measurement device 50 is configured to perform I/Q stitching and/or spectral gluing and/or I/Q gluing, especially where corresponding components overlap. As it can be seen from Fig. 5A or Fig. 5B, respectively, the components "A1", "B1, and "B2" overlap. Accordingly, the measurement device 50 exemplarily performs I/Q stitching with respect to said components "A1", "B1, and "B2". By analogy therewith, as it can further be seen from Fig. 5A or Fig. 5B, respectively, the measurement device 50 exemplarily performs I/Q stitching with respect to the components "B3, "C3, "C4" and to the components "B5", "C5", "C6" and to the components "B7", "C7", "C8".

Moreover, Fig. 5A or Fig. 5B, respectively, indicates that the measurement device 50 according to Fig. 4 allows for reaching a (virtually) simultaneous multi-channel infinite acquisition bandwidth, wherein each channel can have a wider bandwidth than the corresponding measurement hardware or the measurement device 50, respectively, supports.

Advantageously, it is noted that this works without and also with an external trigger signal, for instance, at the corresponding signal period's start). It is further noted that it might be particularly advantageous if an external trigger signal is available or provided, especially to speed-up the measurement, preferably by reducing the corresponding acquisition time and/or making the corresponding alignment or cutting, respectively, of the acquisitions cheaper and/or less complex.

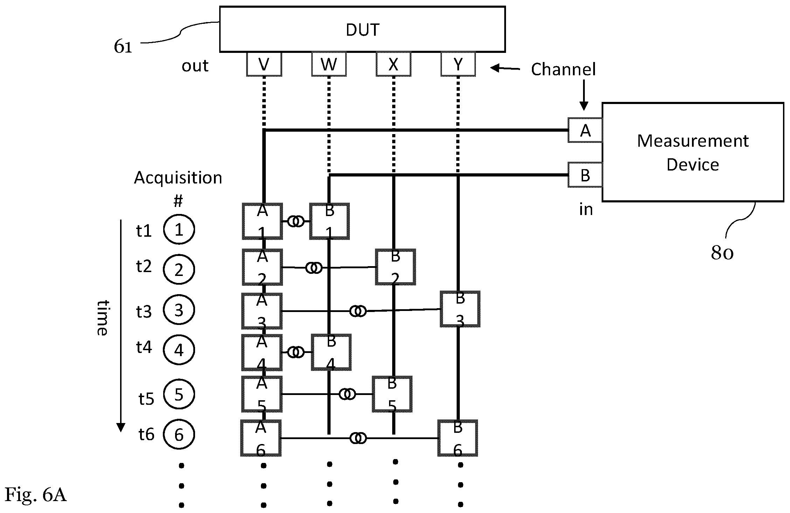

Now, with respect to Fig. 6A, a further exemplary embodiment of a measurement device 80 for performing measurements, especially I/Q data acquisitions, with respect to a device under test 61, DUT, is illustrated in combination with a diagram illustrating the corresponding functioning of said measurement device 80. It is noted that said diagram especially illustrates simultaneous multi-channel acquisition. Accordingly, the measurement device 80 is especially configured to perform simultaneous multi-channel acquisition.

As it can be seen from said Fig. 6A, the measurement device 80, which can exemplarily be a signal analyzer, comprises two radio frequency input channels, namely channel A and channel B. Furthermore, the DUT 61 exemplarily comprises four output channels, especially four radio frequency output channels, namely channel V, channel W, channel X, and channel Y

With respect to the measurement device 80 or the signal analyzer, respectively, it is noted that said measurement device 80 or said signal analyzer, respectively, can comprise more than the two exemplary radio frequency input channels A and B. Furthermore, the DUT 61 can comprise more than the four exemplary output channels V, W, X, Y Advantageously, the measurement device 80 or the signal analyzer, respectively, can measure such a multi-output-channel DUT with many more output channels virtually synchronously. Further advantageously, especially with the aid of using an input signal having a repetitive, exemplarily periodic, nature, a sequence of phase-coherent 2-channel I/Q data acquisitions can be recombined to a (virtual) multi-channel I/Q data acquisition. Afterwards, further multi-channel analysis can follow. As a further advantage, it is noted that the measurement device 80 or the signal analyzer, respectively, can even be used for performing measurements with respect to a machine learned air interface, especially an end-to-end machine learned air interface, or a DUT comprising such an interface, respectively.

For instance, using switches outputs and inputs can be routed per I/Q data acquisition. The measurement device 80 is able to do a simultaneous two-channel acquisition. It is noted that it might be particularly advantageous if the measurement device 80 is configured to perform a time- and/or phase-coherent measurement, preferably a time- and/or phase-coherent data acquisition, more preferably a time- and/or phase-coherent I/Q data acquisition, most preferably a time- and phase-coherent I/Q data acquisition. Especially in this context, local oscillators and/or analog-to-digital converters of the measurement device may preferably be synchronized. Advantageously, the measurement device 80 can work with or without an external trigger, exemplarily an external trigger at the corresponding signal period's start.

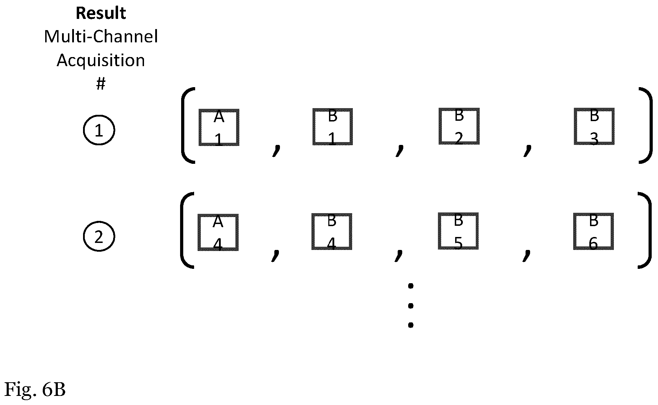

As it can further be seen from Fig. 6A, the above-mentioned diagram of said Fig. 6A shows the sequence of two-channel acquisitions and how the corresponding routing, especially routing regarding the respective DUT output channel to the corresponding measurement device input channel, is done. In this exemplary case according to Fig. 6A, after the third and sixth acquisition, all channels have been captured once and can be therefore recombined into a multi-channel acquisition as exemplarily depicted by Fig. 6B illustrating the corresponding recombination result.

Furthermore, it is noted that a repetitive signal, especially a periodic signal, is exemplarily present at the DUT 61, especially at least the DUT output channel V It is further noted that it might be particularly advantageous if the measurement device 80 is configured to perform an inter-channel synchronization. Accordingly, especially if a simultaneous multi-channel acquisition, exemplarily a simultaneous two-channel acquisition, is performed, the corresponding local oscillators and/or analog-to-digital converters of the measurement paths, exemplarily of the two measurement paths, may preferably be in synchronization, especially phase- and time-coherent.

With respect to said inter-channel synchronization, and in the light of Fig. 6A and Fig. 6B, it is noted that the inter-channel synchronization may especially be understood as a simultaneous phase-coherent acquisition of channels A and B at time *tᵢ*. Accordingly, as it can exemplarily be seen from Fig. 6A, each *Aᵢ* and *Bᵢ* are respectively synchronized in the sense of such an inter-channel synchronization.

Moreover, it might be particularly advantageous if the measurement device 80 is configured to perform an inter-acquisition synchronization. Accordingly, the measurement device 80 may preferably be configured to perform correlation and/or alignment of the corresponding acquisitions distinct in time, especially by making use of the repetitive or periodic nature of the signal or input signal, respectively.

With respect to said inter-acquisition synchronization, and in the light of Fig. 6A and Fig. 6B, it is noted that the inter-acquisition synchronization may especially be understood in a manner that, for instance, *Aᵢ* and *A*_{*i*+1} are synced, preferably with respect to time and phase, exemplarily via correlation, especially using the above-mentioned repetitive or periodic signal nature.

With respect to Fig. 6B, especially the first line thereof (result #1), it is noted that *B*₁ is exemplarily synced with *A*₁, *B*₂ is exemplarily synced with *A*₂, *A*₁ is exemplarily synced with *A*₂ via a correlation, and *B*₂ is exemplarily synced with *A*₁ and *B*₁. For the sake of completeness, it is further noted that in this context, Fig. 6B does not explicitly show that the corresponding single acquisition are cut and synced before assembling.

It is further noted that it might be particularly advantageous if an external trigger signal, especially at the start of the repetitive or periodic signal, is used. Advantageously, less data needs to be captured and the overall measurement time can be faster.

With respect to the above-mentioned input signal or signal, respectively, having the repetitive, exemplarily periodic, nature, it is noted that in accordance with the exemplary embodiment of Fig. 6A, said input signal or signal, respectively, has to be present at least at the output channel V of the DUT 61.

Moreover, as already indicated above, Fig. 6A basically shows how the corresponding routing regarding the respective DUT output channel to the corresponding measurement device input channel is done. Nevertheless, Fig. 6A does not explicitly depict a switches or a switching matrix, respectively. It is noted that the measurement device 80 can be connected via a two-to-four port switching matrix to the DUT 61. For instance, the measurement device 80 can comprise the two-to-four port switching matrix. Accordingly, the two-to-four port switching matrix can be external or internal with respect to a housing of the measurement device 80.

For further example, if even more levels of external and/or internal switches or switching matrixes, respectively, are added, it is possible to scale up to a huge number of DUT output channels to be measured. Advantageously, by such a chaining of switches or switching matrixes, respectively, a multiple-input multiple-output, MIMO, DUT or a massive MIMO DUT, respectively, can be measured.

For instance, for measuring a massive MIMO DUT with 16 channels, a first level may comprise a two-to-four port switching matrix, wherein the measurement device may preferably comprise said first level or said two-to-four port switching matrix, respectively, and a second level may comprise three one-to-five port switching matrixes, wherein said second level or said three one-to-five port switching matrixes may preferably be external to a housing of the measurement device. In this context, one of the 16 DUT channels may be connected to the two-to-four port switching matrix (at the four port side), whereas the remaining 15 DUT channels are may be connected to the three one-to-five port switching matrixes (each at the five port side). In addition to this, each of the three one-to-five port switching matrixes (at the corresponding one port side) may be connected to the two-to-four port switching matrix (at the four port side). It is noted that it might be particularly advantageous if the measurement device comprises a switch controller configured to control each of the first level or the two-to-four port switching matrix, respectively, and the second level or the three one-to-five port switching matrixes, respectively.

Again, with respect to the measurement device 80, it is noted that it might be particularly advantageous if the measurement device 80 is configured to perform continuous measurements. It is further noted that it might be particularly advantageous if the measurement device 80 is configured to perform averaging, especially exponential or rolling averaging, preferably based on performing continuous measurements. Advantageously, multi-channel acquisitions can be outputted after each acquisition or sub-acquisition, respectively, which allows for continuously following the corresponding signal or signal changes, respectively.

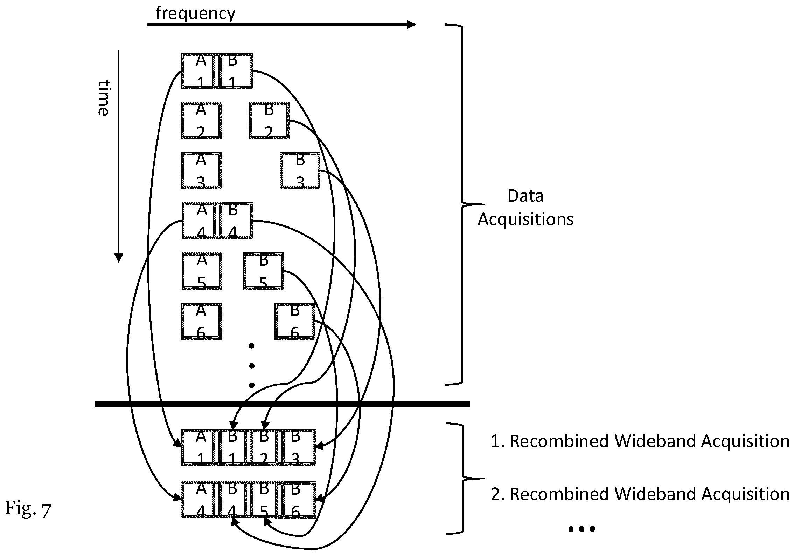

Whereas the above-mentioned diagram of Fig. 6A especially illustrates simultaneous multi-channel acquisition, the diagram shown in Fig. 7 especially illustrates (virtual) infinite acquisition, which can exemplarily be performed by the measurement device 80 according to Fig. 6A. By analogy with the measurement device 50 according to Fig. 4, the measurement device 80 according to Fig. 6A may perform I/Q stitching and/or spectral gluing and/or I/Q gluing, especially to achieve such an infinite acquisition. Such an I/Q stitching is especially illustrated by said diagram of Fig. 7. Advantageously, the measurement device 80 supports an (virtually) unlimited acquisition bandwidth with the same measurement hardware and without the need to develop new hardware again. In other words, the measurement device 80 can (virtually) extend the I/Q acquisition bandwidth ad infinitum, thereby overcoming the limited bandwidth of the corresponding acquisition hardware.

Again, with respect to the input signal or signal, respectively, having the repetitive, exemplarily periodic, nature, it is noted that said input signal or signal, respectively, may comprise a contiguous or non-contiguous spectrum, such as a frequency hopping radar signal, a signal in the context of carrier aggregation, exemplarily as in 5G or satellite applications, or a multi-carrier signal. Advantageously, the repetitive or periodic signal characteristic needs only to be present in a single (even narrow) sub-band.

Again, with respect to the measurement device 80, it is noted that said measurement device 80 may especially perform phase and time synchronous acquisition in two channels A and B. Exemplarily, especially in the light of Fig. 7, the first channel A captures the corresponding first frequency band, that is where the repetitive or periodic nature of the signal is present, and the second channel B is used to step through the rest of the bandwidth until the desired and wide acquisition bandwidth is covered.

As indicated above, said Fig. 7 shows an example with the two parallel running channels A, B running in a continuous measurement mode. Once all sub-bands are captured once, they can be stitched together to obtain the first recombined wideband acquisition. Then, the next round starts with acquisitions A4, B4 and so on until B6 is available where the second recombined wideband acquisitions can be obtained, and so forth.

As also indicated above, especially in the context of (virtual) infinite acquisition, it is noted that it might be particularly advantageous if the corresponding measurement is performed by synchronous, especially phase and/or time synchronous, acquisition in two (or more) channels, especially radio frequency channels. A first channel may preferably capture a first frequency band, where the repetitive or periodic nature of the signal is present. A second channel (or at least one further channel) may preferably be used to step through the rest of the bandwidth until the desired and wide acquisition bandwidth is covered.

It is further noted that it might be particularly advantageous if the corresponding acquisitions, especially in an untriggered situation, take a duration of at least two times the signal period and/or not more than three times, preferably not more than 2.5 times, more preferably not more than 2.2 times, most preferably not more than 2.1 times, the signal period. If multiple periods of the signal are needed, the total acquisition time may preferably be one period longer. Advantageously, such an additional period of the acquisition can be used to do the corresponding correlation and/r alignment, especially in time and/or phase, of subsequent acquisitions. For instance, synchronicity (coherency) between channel A and B of the measurement device 80 can exemplarily be achieved by synchronized local oscillators and prior calibration, which advantageously allows for omitting an external trigger signal.

However, an external or a power or a correlation or a cross-correlation trigger, especially based on a known waveform, can be used to accelerate the corresponding measurement. Advantageously, with such an external trigger, if necessary at all, only a fine synchronization, especially for time and/or phase alignment, may be done before the stitching takes place. Further advantageously, with an external trigger also the duration of one acquisition can be reduced, for instance, to one period plus a few samples at the beginning and at the end. Accordingly, with a trigger, the overall measurement time can be improved.

With respect to the corresponding measurement device performing (virtual) infinite acquisitions as explained above, it is noted that it might be particularly advantageous if the corresponding input mixers of said measurement device are configured such that the respective image frequency bands of the input mixers are suppressed.

Furthermore, especially in the case of a repetitive signal and/or a non-periodic signal, it is noted that it might be particularly advantageous if the corresponding measurement device is configured to average and/or combine multiple acquisitions, especially multiple recombined acquisitions, such that at least one non-repetitive part or each non-repetitive part of the signal disappears and/or is attenuated and/or the repetitive signal parts remain present.

With respect to the above-mentioned untriggered situation or an omission of a trigger, it is noted that, especially as an alternative to such an untriggered situation, it might be particularly advantageous if a heartbeat trigger is used, wherein the corresponding period of said heartbeat trigger is continuously adjusted, especially by the correspondingly detected period start.

Again, with respect to the measurement device 80 according to Fig. 6A, especially in the light of Fig. 7, the first channel A may exemplarily be understood as a reference band. Said reference band can be a certain portion with the same bandwidth as needed for the I/Q stitching or a sub-band with a smaller bandwidth especially for faster measurements. Accordingly, channel A can even be a sub-band of one acquisition of channel B, which can advantageously allow for speeding-up the inter-acquisition synchronization.

With respect to said reference band, it is noted that the corresponding location (center frequency) and/or bandwidth of the reference band can be defined by a user or auto-detected by the measurement device 80. Accordingly, it might be particularly advantageous if the measurement device 80 is configured to automatically detect the location or center frequency, respectively, and/or the bandwidth of the reference band or the first channel A, respectively.

It is further noted that the corresponding acquisition bandwidth can especially be a trade-off between the corresponding maximum possible acquisition bandwidth, especially of the acquisitions of the second channel B, preferably for maximum measurement speed, and a smaller acquisition bandwidth to escape the corresponding spur signals of the measurement device 80, preferably for better dynamics. Accordingly, it might be particularly advantageous if the measurement device 80 is configured to automatically set the corresponding acquisition bandwidth based on a trade-off between the corresponding maximum possible acquisition bandwidth and a smaller acquisition bandwidth to escape the corresponding spur signals of the measurement device 80.

As it can further be seen from Fig. 7, the corresponding overlap of acquisition bands can exemplarily be used for the respective recombination. Advantageously, said overlap is not necessary and not used for respective synchronization and/or correlation. Nevertheless, it might be particularly advantageous if, especially in the context of the measurement device 80, an overlapping band or an additional overlapping band, respectively, is provided for corresponding synchronization.

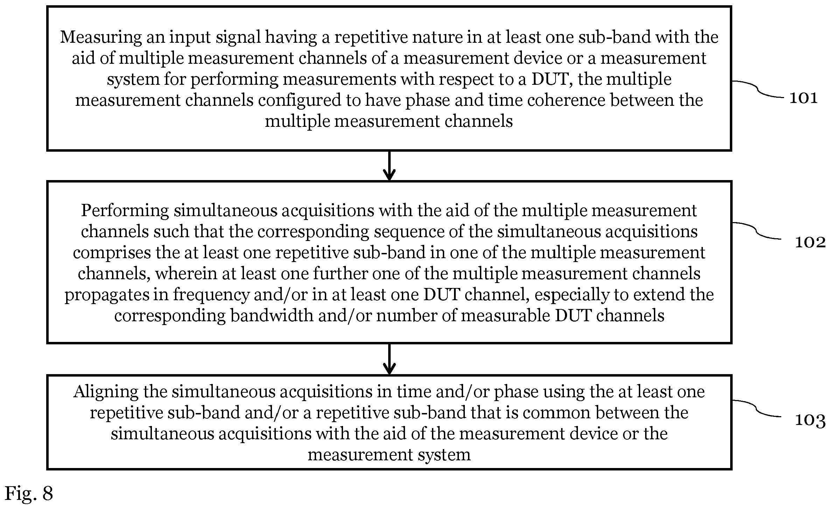

Finally, Fig. 8 illustrates a flow chart of an exemplary embodiment of a measurement method for performing measurements with respect to a device under test, DUT, such as one of the above-mentioned DUTs 11, 31, 61. A first step 101 comprises measuring an input signal having a repetitive nature in at least one sub-band with the aid of multiple measurement channels of a measurement device, such as one of the above-mentioned measurement devices 10, 30, 40, 50, 60, 80 or a measurement system, such as one of the above-mentioned measurement systems 20, 70, for performing measurements with respect to the DUT, the multiple measurement channels configured to have phase and time coherence between the multiple measurement channels. A second step 102 comprises performing simultaneous acquisitions with the aid of the multiple measurement channels such that the corresponding sequence of the simultaneous acquisitions comprises the at least one repetitive sub-band in one of the multiple measurement channels, wherein at least one further one of the multiple measurement channels propagates in frequency and/or in at least one DUT channel, especially to extend the corresponding bandwidth and/or number of measurable DUT channels. Furthermore, a third step 103 comprises aligning the simultaneous acquisitions in time and/or phase using the at least one repetitive sub-band and/or a repetitive sub-band that is common between the simultaneous acquisitions with the aid of the measurement device or the measurement system.

While various embodiments of the present invention have been described above, it should be understood that they have been presented by way of example only, and not limitation. Numerous changes to the disclosed embodiments can be made in accordance with the disclosure herein without departing from the spirit or scope of the invention. Thus, the breadth and scope of the present invention should not be limited by any of the above-described embodiments. Rather, the scope of the invention should be defined in accordance with the following claims and their equivalents.

Although the invention has been illustrated and described with respect to one or more implementations, equivalent alterations and modifications will occur to others skilled in the art upon the reading and understanding of this specification and the annexed drawings. In addition, while a particular feature of the invention may have been disclosed with respect to only one of serveral implementations, such feature may be combined with one or more other features of the other implementations as may be desired and advantageous for any given or particular application.

## Claims

1. A measurement device (10) for performing measurements with respect to a device under test, DUT (11), said measurement device comprising:
multiple measurement channels for measuring an input signal having a repetitive nature in at least one sub-band of at least one DUT (11) channel,
wherein the multiple measurement channels are configured to have phase and time coherence between the multiple measurement channels,
wherein the measurement device (10) is configured to perform simultaneous acquisitions with the aid of the multiple measurement channels such that the corresponding sequence of the simultaneous acquisitions comprises the at least one repetitive sub-band in one of the multiple measurement channels, wherein at least one further one of the multiple measurement channels propagates in frequency and/or switches DUT (11) channels, especially to extend the corresponding bandwidth and/or number of measurable DUT channels, and
wherein the measurement device (10) is configured to align the simultaneous acquisitions in time and/or phase using the at least one repetitive sub-band and/or a repetitive sub-band that is common between the simultaneous acquisitions.

2. The measurement device according to claim 1,
wherein the measurement device (10) is configured to perform an inter-channel synchronization, especially with respect to the multiple measurement channels, and/or
wherein the measurement device (10) is configured to perform an inter-acquisition synchronization, especially with respect to the simultaneous and/or subsequent acquisitions.

3. The measurement device according to claim 1 or 2,
wherein the simultaneous acquisitions comprise or are simultaneous In-phase/Quadrature, I/Q, data acquisitions, and/or
wherein the repetitive nature comprises or is a periodic nature.

4. The measurement device according to any of the preceding claims,
wherein the measurement device (10) is configured to cross-correlate and/or average and/or combine the simultaneous acquisitions, especially over correspondingly subsequent acquisitions.

5. The measurement device according to any of the preceding claims,
wherein the measurement device (10) comprises at least one filter, especially a filter bank, for filtering the simultaneous acquisitions and/or for dividing the simultaneous acquisitions into corresponding multiple sub-bands.

6. The measurement device according to any of the preceding claims,
wherein the measurement device (10) is connectable and/or connected to a splitting and/or switching matrix, especially for mapping the corresponding DUT (11) channels to the multiple measurement channels, preferably at certain acquisition times,
wherein preferably the measurement device comprises the splitting and/or switching matrix, and/or
wherein preferably the measurement device is configured to perform a de-embedding of the splitting and/or switching matrix.

7. A measurement method for performing measurements with respect to a device under test, DUT (11) , comprising the steps of:
- measuring an input signal having a repetitive nature in at least one sub-band with the aid of multiple measurement channels of a measurement device or a measurement system for performing measurements with respect to the DUT (11), the multiple measurement channels configured to have phase and time coherence between the multiple measurement channels,
- performing simultaneous acquisitions with the aid of the multiple measurement channels such that the corresponding sequence of the simultaneous acquisitions comprises the at least one repetitive sub-band in one of the multiple measurement channels, wherein at least one further one of the multiple measurement channels propagates in frequency and/or switches DUT channels, especially to extend the corresponding bandwidth and/or number of measurable DUT channels, and
- aligning the simultaneous acquisitions in time and/or phase using the at least one repetitive sub-band and/or a repetitive sub-band that is common between the simultaneous acquisitions with the aid of the measurement device or the measurement system.

8. A measurement device (10) for performing measurements with respect to a device under test, DUT (11), said measurement device comprising:
multiple measurement channels for measuring an input signal having a repetitive nature in at least one sub-band,
wherein the multiple measurement channels are configured to have phase and time coherence between the multiple measurement channels,
wherein the measurement device (10) is configured to perform simultaneous acquisitions with the aid of the multiple measurement channels such that the corresponding sequence of the simultaneous acquisitions comprises the at least one repetitive sub-band in one of the multiple measurement channels, wherein at least one further one of the multiple measurement channels propagates in frequency, especially to extend the corresponding bandwidth, and
wherein the measurement device (10) is configured to align the simultaneous acquisitions in time and/or phase using the at least one repetitive sub-band and/or a repetitive sub-band that is common between the simultaneous acquisitions,
wherein preferably the measurement device (10) is configured to perform an inter-channel synchronization, especially with respect to the multiple measurement channels, and/or
wherein preferably the measurement device (10) is configured to perform an inter-acquisition synchronization, especially with respect to the simultaneous and/or subsequent acquisitions.

9. The measurement device according to claim 8,
wherein the simultaneous acquisitions comprise or are simultaneous In-phase/Quadrature, I/Q, data acquisitions, and/or
wherein the repetitive nature comprises or is a periodic nature.

10. The measurement device according to any of claims 8 or 9,
wherein the measurement device is configured to cross-correlate and/or average and/or combine the simultaneous acquisitions, especially over correspondingly subsequent acquisitions.

11. The measurement device according to any of claims 8 to 10,
wherein the measurement device comprises at least one filter, especially a filter bank, for filtering the simultaneous acquisitions and/or for dividing the simultaneous acquisitions into corresponding multiple sub-bands.

12. The measurement device according to any of claims 8 to 11,
wherein the measurement device is connectable and/or connected to a splitting and/or switching matrix, especially for mapping the corresponding DUT channels to the multiple measurement channels, preferably at certain acquisition times,
wherein preferably the measurement device comprises the splitting and/or switching matrix, and/or wherein preferably the measurement device is configured to perform a de-embedding of the splitting and/or switching matrix.

13. A measurement device for performing measurements with respect to a device under test, DUT, said measurement device comprising:
multiple measurement channels for measuring an input signal having a repetitive nature in at least one sub-band,
wherein the multiple measurement channels are configured to have phase and time coherence between the multiple measurement channels,
wherein the measurement device is configured to perform simultaneous acquisitions with the aid of the multiple measurement channels such that the corresponding sequence of the simultaneous acquisitions comprises the at least one repetitive sub-band in one of the multiple measurement channels, wherein at least one further one of the multiple measurement channels propagates in at least one DUT channel, especially to extend the corresponding number of measurable DUT channels, and
wherein the measurement device is configured to align the simultaneous acquisitions in time and/or phase using the at least one repetitive sub-band and/or a repetitive sub-band that is common between the simultaneous acquisitions.

14. The measurement device according to claim 13,
wherein the measurement device is configured to perform an inter-channel synchronization, especially with respect to the multiple measurement channels, and/or
wherein the measurement device is configured to perform an inter-acquisition synchronization, especially with respect to the simultaneous and/or subsequent acquisitions.

15. The measurement device according to claim 13 or 14,
wherein the simultaneous acquisitions comprise or are simultaneous In-phase/Quadrature, I/Q, data acquisitions, and/or
wherein the repetitive nature comprises or is a periodic nature.
